# EUROPÄISCHE PATENTANMELDUNG

(11) **EP 1 318 521 A1**
(43) Veröffentlichungstag der Anmeldung: **11.06.2003**
(21) Anmeldenummer: 02027205.0
(22) Anmeldetag: 05.12.2002
(51) Int. Cl.: G11C 7/10

(54) **Speichermodul**

(30) Priorität: 06.12.2001 DE 10159956
(71) Anmelder: SIEMENS AKTIENGESELLSCHAFT, 80333 München (DE)
(72) Erfinder: Epp, Wolfgang, 76744 Wörth (DE); Klamm, Arnold, 76870 Kandel (DE); Michalk, Detlev, 76189 Karlsruhe (DE); Schönemann, Konrad, 75056 Sulzfeld (DE)

(57) **Zusammenfassung**

Die Erfindung betrifft ein Speichermodul, das wenigstens ein Speicherelement (2, 3) und einen Direktstecker (4) auf einer Karte (1) umfasst und das durch ein Rechnerprotokoll asynchron beschrieben und ausgelesen wird.

Um den Bedarf an kostengünstigen Speichermodulen zu decken, die in der Anwendung wie ein asynchrones DRAM-Modul betrieben werden, bei denen jedoch nicht mehr auf asynchrone Speicherelemente zurückgegriffen werden muss, ist das wenigstens eine Speicherelement (2, 3) des Speichermoduls erfindungsgemäß ein synchrones Speicherelement und ist ein Logikschaltkreis (5) zwischen dem wenigstens einen synchronen Speicherelement (2, 3) und dem Direktstecker (4) des Moduls angeordnet, der eine Übersetzung des Rechnerprotokolls in ein Speicherprotokoll und umgekehrt durchführt.

## Beschreibung

Die Erfindung betrifft Speichermodule nach dem Oberbegriff von Anspruch 1.

Die Entwicklung der dynamischen Schreib-/Lese-Speicher (DRAM) schreitet sehr schnell voran. Vor einiger Zeit wurden Speichermodule entwickelt, die auf der Verwendung von asynchronen DRAMs basieren, nämlich "extended data out"- (EDO-) bzw. "fast page mode"- (FPM-) DRAMs. Diese DRAM-Speicherelemente haben eine Zugriffszeit von 60 bis 70 ns. Höhere Datenraten als die asynchronen DRAM-Speicherelemente bieten Speicherelemente auf Basis synchroner DRAMs (SDRAM). Daher wurde seither die Produktion der asynchronen DRAMs immer weiter zugunsten der synchronen DRAMs reduziert.

In vielen Bereichen werden jedoch nach wie vor auf asynchronen DRAMs basierende Speichermodule eingesetzt. Für die Anwender dieser Module ist es zunehmend schwieriger, geeignete asynchrone Speicherelemente zu bekommen.

Es besteht daher Bedarf an kostengünstigen Speichermodulen, die in der Anwendung wie ein asynchrones DRAM-Modul betrieben werden, bei denen jedoch nicht mehr auf asynchrone Speicherelemente zurückgegriffen werden muss.

Diese Aufgabe wird erfindungsgemäß durch ein Speichermodul gemäß Anspruch 1 gelöst. Bevorzugte Ausführungsformen der Erfindung sind Gegenstand der Unteransprüche.

Erfindungsgemäß werden zur Realisierung von asynchronen Speichermodulen synchrone Speicherelemente verwendet. Die Ansteuerung von asynchronen und synchronen DRAMs unterscheidet sich aber in einigen wesentlichen Punkten. Die Erfindung löst dieses Problem, indem zwischen den auf dem Modul bestückten SDRAMs und dem Direktstecker des Moduls ein kundenspezifischer Schaltkreis (konfigurierbarer Logik-Schaltkreis) geschaltet wird, der eine Übersetzung der verschiedenen Protokolle durchführt. Dadurch wird erreicht, dass sich das Modul auf der Busseite wie ein EDO- oder FPM-DRAM-Modul verhält, aber intern die Ansteuerung für synchrone DRAMs vorhanden ist.

Das erfindungsgemäße Speichermodul, das wenigstens ein Speicherelement und einen Direktstecker auf einer Karte umfasst und das durch ein Rechnerprotokoll asynchron beschrieben und ausgelesen wird, ist dadurch gekennzeichnet, dass das wenigstens eine Speicherelement des Speichermoduls ein synchrones Speicherelement ist, ein Logikschaltkreis zwischen dem wenigstens einen synchronen Speicherelement und dem Direktstecker des Moduls angeordnet ist, der eine Übersetzung des Rechnerprotokolls in ein Speicherprotokoll und umgekehrt durchführt.

Vorzugsweise ist der Logikschaltkreis ein programmierbares Bauelement (PLD), das anwendungsabhängig konfiguriert ist (ASIC).

Ein Vorteil der Erfindung besteht darin, dass man ein Modul mit sehr wenigen Komponenten günstig aufbauen kann, da die heute erhältlichen SDRAMs im Vergleich zu den älteren asynchronen DRAMs eine sehr hohe Kapazität haben. Der Preis für synchrone DRAMs ist momentan sehr niedrig, wogegen der Preis für asynchrone Elemente bedingt durch die geringe verfügbare Stückzahl immer höher wird. Durch die erfindungsgemäße Verwendung von synchronen Speicherelementen mit geringen Bauteilkosten wird es damit möglich, die Kosten hochpreisiger Module zu senken.

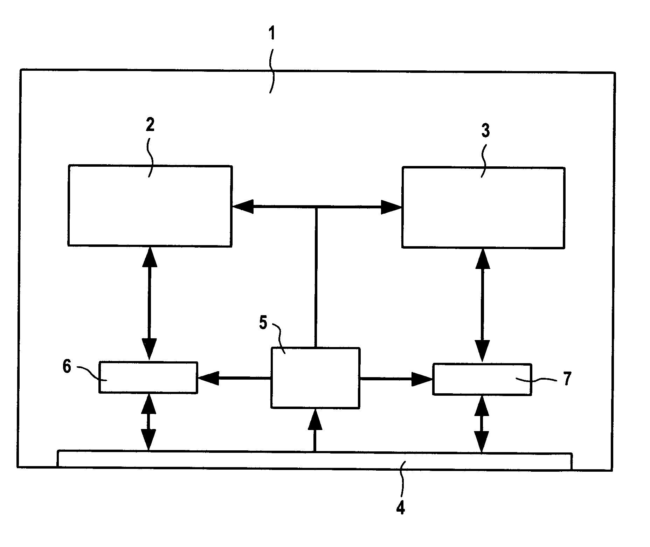

Weitere Merkmale und Vorteile der Erfindung ergeben sich aus der folgenden Beschreibung eines bevorzugten Ausführungsbeispiels, bei der Bezug genommen wird auf die beigefügte Zeichnung.

Die Figur zeigt ein Blockschaltbild eines Speichermoduls gemäß der Erfindung.

Das Speichermodul in der Figur umfasst zwei Speicherelemente 2 und 3 auf einer Karte 1. Die Karte 1 ist über einen Direktstecker 4 mit z. B. einem (nicht dargestellten) Motherboard verbunden.

In dem Speichermodul werden temporär Daten abgelegt, d. h., sie müssen im Verlauf von Arbeitsschritten bei der Durchführung von Programmen nach dem Start des Rechners von einem (nicht dargestellten) Zentralprozessor in den Speicher geschrieben werden. Bei Bedarf werden sie von dem Zentralprozessor wieder ausgelesen usw. Beim Ausschalten des Rechners, d. h. bei Unterbrechung der Stromversorgung des Speichermoduls, gehen die darin abgespeicherten Daten verloren. Darüber hinaus müssen die Daten auch bei eingeschalteter Stromversorgung in regelmäßigen Intervallen aufgefrischt werden. Die Kommunikation zwischen dem Zentralprozessor und dem Speichermodul ist durch ein Rechnerprotokoll geregelt.

Bei Speichermodulen, die asynchron beschrieben und ausgelesen werden, ist es wie oben erläutert ein Problem, preiswerte Speicherelemente zu finden. Erfindungsgemäß werden daher als Speicherelemente 2 und 3 des Speichermoduls synchrone Speicherelemente eingesetzt. Da das Protokoll, mit dem das Auslesen und Beschreiben der Speichermodule durch den Zentralprozessor geregelt wird, von der Art der Speicherelemente 2 und 3 des Speichermoduls abhängt, wird erfindungsgemäß ein Logikschaltkreis 5 am Eingang des Speichermoduls vorgesehen, d. h. unmittelbar hinter dem Direktstecker 4 des Moduls. Dieser Logikschaltkreis 5 zwischen dem synchronen Speicherelement 2 bzw. 3 und dem Direktstecker 4 sorgt für eine Übersetzung des Rechnerprotokolls in ein Speicherprotokoll und umgekehrt. Das Speicherprotokoll dient dazu, die Speicherelemente anzusprechen; das Rechnerprotokoll dient zur Kommunikation zwischen Zentralprozessor und Speichermodul. Dadurch wird erreicht, dass sich für den Anwender das Speichermodul mit synchronen Speicherelementen nach außen wie ein asynchrones Speichermodul verhält.

Zwischen den Speicherelementen 2 bzw. 3 und dem Direktstecker 4 der Modulkarte 1 sind ein erstes Pufferregister 6 bzw. zweites Pufferregister 7 geschaltet, die von dem Logikschaltkreis 5 angesteuert werden. Über diese Register 6 und 7 erfolgt das Lesen und Schreiben in den Speicherelementen 2 und 3, während die Adressierung der Speicherbereiche in den Speicherelementen 2 und 3 über den Logikschaltkreis 5 selbst erfolgt. Der Datenaustausch ist in der Figur durch Doppelpfeile angedeutet, die Adressierung erfolgt über die Verbindungen, die durch einen einfachen Pfeil dargestellt sind.

Das erfindungsgemäße Speichermodul unterscheidet sich daher optisch von einem Speichermodul nach dem Stand der Technik dadurch, dass zusätzliche Logikschaltkreise vorgesehen sein müssen.

Vorzugsweise handelt es sich bei dem Logikschaltkreis 5 um einen anwendungsspezifischen Schaltkreis (ASIC), der als programmierbarer Logikbaustein (programmable logic device) aufgebaut ist.

## Patentansprüche

1. Speichermodul, das wenigstens ein Speicherelement (2, 3) und einen Direktstecker (4) auf einer Karte (1) umfasst und das durch ein Rechnerprotokoll asynchron beschrieben und ausgelesen wird,
**dadurch gekennzeichnet, dass**
das wenigstens eine Speicherelement (2, 3) des Speichermoduls ein synchrones Speicherelement ist,
ein Logikschaltkreis (5) zwischen dem wenigstens einen synchronen Speicherelement (2, 3) und dem Direktstecker (4) des Moduls angeordnet ist, der eine Übersetzung des Rechnerprotokolls in ein Speicherprotokoll und umgekehrt durchführt.

2. Speichermodul nach Anspruch 1,
**dadurch gekennzeichnet, dass**
der Logikschaltkreis (5) ein programmierbares Bauelement (PLD) ist, das anwendungsabhängig konfiguriert ist (ASIC).
